# EUROPEAN PATENT SPECIFICATION

(11) **EP 1 899 738 B1**
(45) Date of publication and mention of the grant of the patent: **18.03.2009**
(21) Application number: 06762479.1
(22) Date of filing: 07.07.2006
(51) Int. Cl.: G01R 31/319, G01R 31/28

(54) **TEST APPARATUS WITH TESTER CHANNEL AVAILABILITY IDENTIFICATION**
TESTVORRICHTUNG MIT TESTERKANAL-VERFÜGBARKEITSIDENTIFIKATION
APPAREIL D'ESSAI A IDENTIFICATION DE DISPONIBILITE DE CANAUX D'ESSAI

(30) Priority: 07.07.2005 US 176928
(43) Date of publication of application: 19.03.2008
(73) Proprietor: Verigy (Singapore) Pte. Ltd., Singapore 768923 (SG)
(72) Inventor: BERTONCELLI, Domenico, I-20060 Pessano con Bornago (MI) (IT); ARCA, Fabrizio, I-05100 Terni (TR) (IT)
(74) Representative: Schoppe, Fritz
(86) International application number: PCT/EP2006/006669
(87) International publication number: WO 2007/006501

(56) References cited:
- US-A1- 2005 071 715
- US-B1- 6 185 708

## Description

### Background art

The invention relates to testing a device, under test.

Integrated. Circuits (IC) need to be tested to assure proper operation. During testing, an IC, as a device under test (DUT), is exposed to stimulus data signals of an Automatic Test Equipment (ATE). The IC transmits corresponding response data back to the ATE. The ATE measures, processes and usually compares this response data with expected responses. The ATE usually performs these tasks according to a device-specific test program. ATE's with decentralized resources based on a per-pin architecture are known, wherein during test, each pin of a plurality of pins of the DUT is connected to one ATE pin electronic. The per-pin architecture generally enables high performance and scalability.

Examples of ATE's with per-pin architecture are the Agilent 83000 and 93000 families of Semiconductor Test Systems by Agilent Technologies. Details of those families are disclosed e.g. in EP-A-0 859 318, EP-A-0 864 977, EP-A-0 886 214, EP-A-0 882 991, US-A-5 499 248 and US-A-5 453 995.

Essentially, testing apparatus of the kind considered in the foregoing is made up by a series of tester channels, acting each as an independent tester machine. For instance, in an Agilent 93000 (93K) testing apparatus, the tester channels are grouped in boards, each board containing 16 channels, and in the standard 93K configuration, the Agilent tester machine in question includes up to 1024 tester channels.

When even a single tester channel is affected by malfunctioning, then a "down" of the whole tester machine occurs. Any channel malfunctioning thus leads to downtime in the tester machine as a whole, and the main reason for tester downtime is thus malfunctioning of any of these channels. Machine downtime strongly affects production throughput, and the costs associated with testing. In any case, such "down" events negatively impact on machine reliability.

When channel malfunctioning occurs, the following steps might be taken:
a) testing is stopped; the tester is DOWN;
b) diagnostic software is run to locate the malfunctioning channel;
c) the channel board containing the channel that failed must be replaced by a new board; this is handled as a spare part, which requires placing an order to a source of spare parts and typically involves a time of delivery of 24-48 hours;
d) once received, the new board is installed by a trained technician;
e) diagnostic software is again run (this requires 1 hour on the average); and
f) self-calibration is typically performed (3 hours average)

Only at this point of time, the ATE tester machine will be "up" and running again.

Machine downtime, i.e. the time the machine is not working, will add up to the sum of the times required for all of the operations a) to f) described in the foregoing.

US 6,185,708 B1 discloses a test system for testing a semi-conductor device having a plurality of tester pins corresponding to the number of terminal pins of the device under test. The system is implemented as a maintenance free semi-conductor test system in which a user of the test system does not need to take any measures or maintenance works against failures or defects, in the semi-conductor test system. When a defect is discovered in a tester pin of the test system, a maintenance process will be automatically conducted in which the defective tester pin may be replaced with an interchangeable tester pin. The automatic interchanging of the tester pin is performed by a pin assignment converter provided between the test controller and the test unit for providing conversion data showing a conversion relationship between physical pin numbers of the test unit and the supplemented test pin numbers which have to be replaced with defective tester pins to the test unit. In addition, a switch circuit is provided between the test head and the device under test for changing the defective tester pin to the supplementary tester pin based on the conversion data from the pin assignment converter.

### Disclosure

An object of the invention is to provide an improved testing a device under test. These and other objects are achieved by means of the invention as defined in the claims that follow.

A basic idea underlying a preferred embodiment of the invention is to automatically "swap" for the malfunctioning tester channel another channel that is available and is a "good" one, i.e. properly operating.

Preferably, this swapping or switching action is performed through a software (S/W) switch and a hardware (H/W) switch. A number of alternatives are available for implementing such a H/W switch function. These alternatives may involve switching inside the ATE (e.g. switches between neighboring channels), the DUT board design (i.e. relays on the DUT board), or using reconfigurable scan chains.

So, while waiting for the new tester board that should replace the board containing the failing channel, the tester machine itself will not stop testing. This reduces the downtime of semiconductor testing apparatus such as Automated Test Equipment or ATE.

Preferably, the tester software operates on the basis of certain files stored in the tester program directory, i.e.:
- a) model file: this file contains information regarding all the channels of the tester available in the tester itself;
- b) pinconfig file: this is a pin configuration file contains information regarding all the channels of the tester used by a test program;
- c) diagnostic log file: this file contains information regarding the failing channels on the tester.

When malfunctioning is detected by diagnostic software in a tester channel, a script such as a PERL (Practical Extraction and Reporting Language) script will automatically replace the malfunctioning tester channel with another channel available in the tester.

In an embodiment, a semiconductor testing apparatus is provided in the form of a self-detecting, self-repairing, and virtually downtime-exempt machine.

### Brief description of the drawings

Embodiments of the present invention will now be described, by way of non-limiting examples, with reference to the attached figures of drawing, in which:
- figure 1 is a schematic, partially exploded perspective view of test apparatus adapted to incorporate the arrangement described therein,
- figure 2 is a functional block diagram of apparatus as shown in figure 1,
- figure 3 is a flow chart representative of possible operation of semiconductor testing apparatus as described herein.

In the following description, numerous specific details are given to provide a thorough understanding of embodiments of the invention. One skilled in the relevant art will recognize, however, that the invention can be practiced without one or more the specific details or with other methods, components, materials and so on.

In other instances, well-known structures, materials, or operations are not shown or described in detail to avoid obscuring aspects of the invention.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessary or referring to the same embodiment. Furthermore, the particular features, structures, or characteristic may be combined in any suitable manner in one or more embodiments.

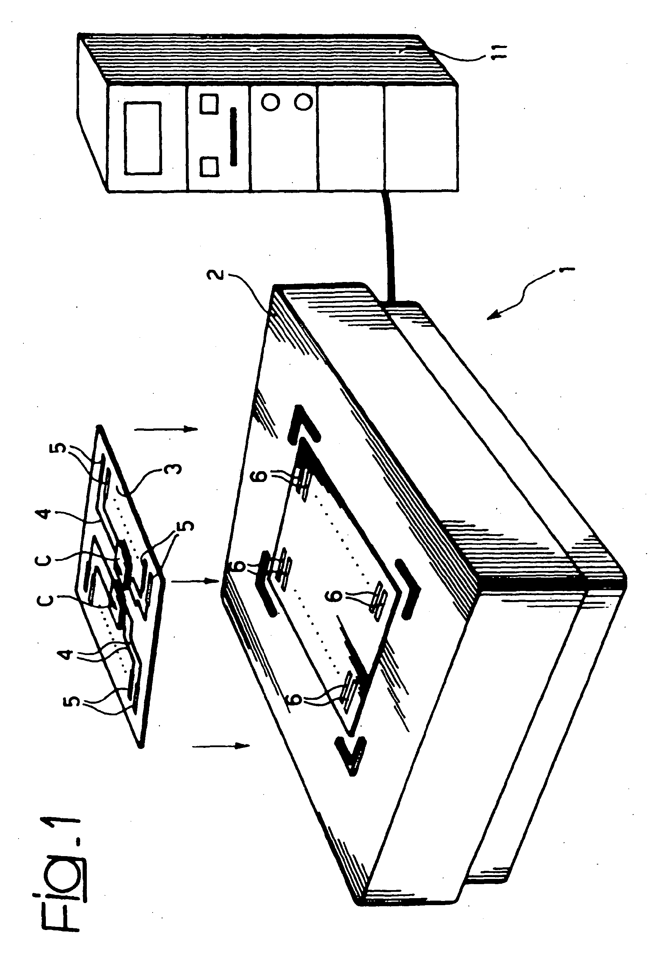

Figure 1 is a schematic prospective view of apparatus 1 for use in testing Integrated Circuits (IC's) in order to assure proper operation thereof. During testing, an IC, as a device under test (DUT), is exposed to stimulus data signals generated by the Automatic Test Equipment (ATE) 1. The IC transmits corresponding response data back to the ATE. The ATE measures, processes and usually compares this response data with expected responses. The ATE usually performs these tasks according to a device-specific test program.

In a typical exemplary arrangement the equipment (ATE) 1 includes a bench structure 2 onto which the Devices Under Test (DUTs) are arranged.

Specifically, in the view of figure 1, one or more DUTs in the form of semiconductor integrated circuits C are shown mounted a DUT board 3. The DUT board 3 is essentially in the form of a large (e.g. 60x40 cm) printed circuit (PC) board including a central portion onto which the devices C are arranged. The DUT board 3 includes a large plurality of lines 4 each of which connects one pin or contact ("ball") of a device under test - which may be a packaged device as well as a "naked" chip - to at least one connecting pad arranged at the board periphery. These connecting pads are typically arranged in arrays 5 at the lower side (underside) of the board 3..

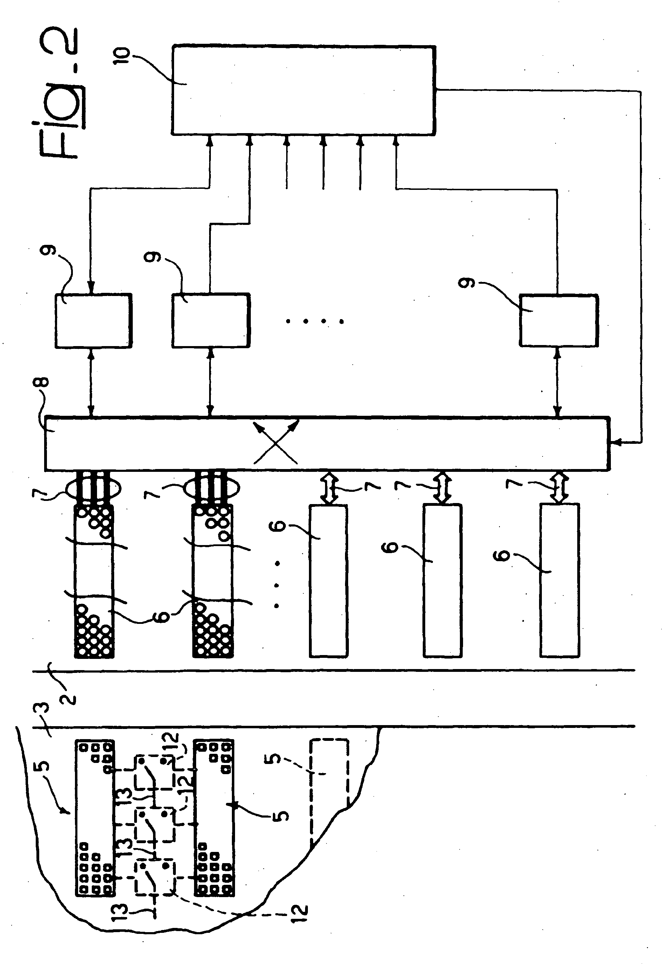

As better shown in figure 2, each array 5 is usually comprised of a matrix of contact pads. Each such array 5 in the DUT board is mirrored by a corresponding array 6 of contact pins at the upper plane of the bench portion 2 of the ATE 1. These contact pins (currently referred to as "pogo pins") establish electrical connection to the contact pads 5 and thus to the pins or "balls" of the devices C under test.

During the test process, the connections established via lines 4, the contact pads in the arrays 5 and the "pogo pins" 6 are used to apply to the circuits C signals in the form of "stimuli" and to collect corresponding "reactions" or "responses" from the circuits. The absence of these reactions/responses or these reactions/responses being different from those expected is generally construed as evidence of fault or malfunctioning of any circuit C tested.

All of the foregoing corresponds to principles of operation that are well known in the art, thus making it unnecessary to provide a more detailed description herein.

As better detailed in figure 2, each array of pogo pins 6 represents the "distal" end of a corresponding tester channel 7. Each such channel is connected, via a switch matrix 8 to be better detailed in the following, to a tester board 9. Typically ATEs of the Agilent 93k series include 1024 channels grouped in 64 boards, each board thus having associated therewith 16 channels. The tester boards 9 are typically arranged in the bench structure 2 of the ATE and come down to a main tester unit 10 housed in a central shelf 11 where user interfaces (GUIs and the like) are arranged.

Malfunctioning of any of the tester channels 7 is a highly undesirable event, and the unit 10 includes software automation to detect malfunctioning channels.

In the presently preferred embodiment of the arrangement described herein, defective channel detection is performed by means that are known per se, e.g. via the diagnostic routines already available in the software module designated HPSmartest™ equipping the Agilent 93K test machinery.

The tester software operates on the basis of certain files stored in the associated memory of the unit 10. Specifically, these files, as included in the tester program directory are:
- a) a model file: this file contains information regarding all the channels of the tester available in the tester itself;
- b) a pinconfig file: this is a pin configuration file contains information regarding all the channels of the tester used by a test program; and
- c) a diagnostic log file: this file contains information regarding the failing channels on the tester.

A basic concept underlying the arrangement described herein lies in that, if one of the channels 7 is found to be defective, another good but unused channel 7 replaces the defective channel in the pinconfig file.

Specifically, a script such a PERL script replaces the defective channel with the good one in the pinconfig file. The good but unused channel then physically replaces the defective channel on the DUT board.

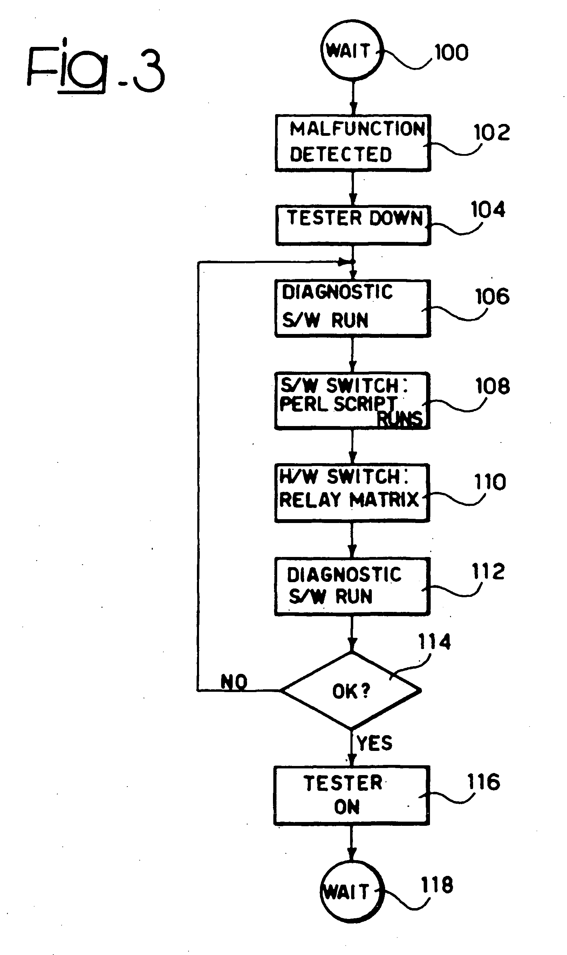

An exemplary mode of operation of the arrangement just considered will now be described with reference to the flow-chart of figure 3.

Starting from a WAIT state 100, which is exemplary of regular operation of the tester equipment, a step 102 is representative of a tester channel malfunctioning event being detected (as indicated, this function is performed by known means, not illustrated in detail herein).

As a consequence, in a step 104 testing operation is discontinued. The tester equipment 1 is DOWN.

Then, in a step 106 diagnostic software is run (this is already available as a part of the Agilent 93K tester software), and the malfunctioning channel 7 is identified.

In a step 108 a script such as e.g. a PERL (Practical Extraction and Reporting Language) script scans the log file described in the foregoing to find out the malfunctioning channel. Specifically, the script scans two of the files included in the tester software directories stored in the unit 10, namely:
- i) a model file containing information regarding all the channels of the tester available in the tester itself (i.e. the "tester channels") and
- ii) a pin configuration file ("pinconfig file") containing information regarding all the channels of the tester used by test program (i.e. the "used channels").

The script scans and compares the model and pinconfig file finding out the tester channels that are available and not used. The script achieves this result by comparing the groups "tester_channels" vs. "used_channels".

The PERL script thus finds out a group of "spare_channels". Any channel belonging to the group "spare_channels" can be used to replace a malfunctioning channel belonging to the group of "used_channels".

The script modifies the pinconfig file by replacing the channel 7 found to be malfunctioning with an operative channel taken from the group "spare_channels". In that way, a switching action is performed by' replacing a malfunctioning channel with a channel that is both available and a "good" one.

Then, in a step 110, physical switching is performed to substitute the tester channel 7 found to be malfunctioning by means of another tester channel that is available and is a "good" one, i.e. a tester channel adapted to ensure proper tester operation.

A number of options are available for performing the "physical" switching action considered here.

A first, presently preferred option relies on the switch matrix 8 shown in figure 2. In a preferred embodiment, the matrix in question is a solid state relay switch matrix. Such switch matrixes are commonly used in a wide variety of electronic devices such as e.g. private and public exchanges in telephone networks. Use of those matrixes has also been proposed in ATE's, for instance for testing so-called "stacks" including a plurality of superposed devices having respective layers of pins or "balls" that require different connection arrangements for testing the various devices in the stacks.

In brief, once a given channel 7 is found to be malfunctioning, the matrix 8 (which operates under the control of the unit 10) ensures that the array of "pogo pins" 6 and the tester board 9 connected via the malfunctioning channel are re-connected via a "good" channel, thus ensuring the possibility of continuing the test process.

As an alternative, a corresponding mode of operation can be ensured by resorting to a dedicated board design for all channels through relays 12 (schematically shown in phantom line in figure 2) included in the DUT board 3. In that way, all channels 7 may be connected to respective relays 12 that will be responsible to replace any failing channel with a channel that is operative and not currently used. While not unlikely to increase to some extent surface occupancy of the DUT board 3, this alternative arrangement has an inherent advantage in that the switch relays 12 can be controlled by the unit 10 via so-called "utility" lines 13 that are already currently available on the DUT board 3.

Still a further alternative (not explicitly shown in the drawings) provides for "virtual" switching along the lines described in the foregoing being achieved via corresponding changes in the so-called "scan-chains" of the devices C.

Whatever the specific option adopted for channel H/W switching, once such channel switching has been achieved, in a step 112, a diagnostic software is run. If such diagnostic routine provides a positive result (step 114), the tester is set ON so that testing is restarted (step 116), while the system returns to the WAIT condition (step 118). In the case of a negative result in step 114, operation of the system returns to the step 106.

The steps described in the foregoing are preferably integrated to a single step software process in that the diagnostic routine itself, once having detected a malfunctioning channel, will call the PERL script. This means that the steps described above will in fact be integrated into the diagnostic routine, running in automatic mode after any tester stop due to a malfunctioning being detected.

It will be appreciated that the type of operation described embodies the concept of a truly self detecting/repairing tester machine. Additionally, those of skill in the art will appreciate that the arrangement just described lends itself to introducing redundant spare channels in a tester machine for use if the testing apparatus is already using all the tester channels available.

Pseudo-code representative of a PERL script adapted for use within the framework of the arrangement described herein will now be described in detail.

The main program of the script executes the following functions :

| | | |
|---|---|---|
| &scan_diag(); | # | from diagnostic file finds out tester failing channels |
| &scan_model(); | # | from model file finds out tester available channels |
| &scan_config(); | # | from pin config file finds out tester used channels |
| &scan_free(); | # | finds out tester free channels |
| &backup_config(); | # | creates a backup of pin config |
| &modify_config(); | # | replaces in pin config failing_channels with available_channels |

By scanning this part of the model file, &scan_model() finds out the available channels in the tester i.e. the "tester_channels"):
IOCHANNEL
   10101-10216: sram = 2M, sdram = 112M
   10301-11416: sram = 2M, sdram = 14M
   11501-11616: sram = 2M, sdram = 112M
   11701-13216: sram = 2M, sdram = 14M
   20101-20516: sram = 2M, sdram = 14M
   .........................

By scanning this part of the pinconfig file, &scan_config() finds out the channels of the tester used by the test program (i.e. the "used_channels"):
hp93000,config,0.1
DFPN 10702,"3",(cari_pwm)
DFPN 10703, "4", (paper_pwm)
DFPN 10704,"5", (servywm_b)
DFPN 10705,"8",(rom_adr18)
DFPN 10706,"9",(serv_pwm_a)
DFPN 10707,"10",(aload)
DFPN 10708,"11",(obs_bus13)
..........................

Then, &scan_free() finds out the tester channels that are free and &modify_config() replaces in pin config the failing_channel with available_channels.

At this point a warning is issued on the display of the Tester Machine :
print "\n\n\n\n";
print " !!!!!ATTENTION!!!!! THIS CHANNEL IS FAILING: $failing_channels[$t]\n";
print " REPLACE IT ON THE BOARD WITH THIS UNUSED CHANNEL: $free_channels[$t]\n";
print "\n\n";
print " PIN CONFIGURATION HAS BEEN ALREADY UPDATED BY THIS SCRIPT ";

The diagnostic software (step 106) can be run on the tester manually, by a technician, after an error occurred in the tester. However, the arrangement described herein preferably contemplates the possibility for this software to be run periodically, when the machine is STOPPED but not DOWN, i.e. behaving essentially like the SCANDISK program running on a PC. If a failing channel is detected, then the channel switch/swap procedure described is started automatically.

It will be appreciated that the arrangement described herein provide an appreciable increase in the uptime of the testing equipment described by improving performance thereof in terms of mean time between failures (MTBF). This is particularly important, especially for high pin count digital systems expected to be used in cost sensitive multi-site environments.

The arrangement described herein involves the use of relays (relay unit 20) on the DUT board. For certain applications such an arrangement may turn out not to be particularly practical because of space and reliability concerns. The switching process described in the foregoing can however be performed elsewhere within the automated test equipment (ATE), for instance by arranging switches between neighboring channels or within the device under test (DUT), by using e.g. reconfigurable scan chains.

The above description of illustrated embodiments of the invention, including what is described in the abstract, is not intended to be exhaustive or to limit the invention to the precise form disclosed. While specific embodiments of, and examples for, the invention are described herein for illustrative purposes, various equivalent modifications are possible within the scope of the invention.

These and other modifications can be made to the invention in light of the above detailed description. Rather, the scope of the invention is to be determined entirely by the following claims, which are to be construed in accordance with established doctrines of claim interpretation.

## Claims

1. An automated tester apparatus (10) comprising:
a first tester channel (7) and a second tester channel (7);
a model file that indicates whether said first and second tester channels (7) are available in the tester apparatus;
a pin configuration file that indicates whether said first and second tester channels (7) are used by a test program; and
a tester software arranged for scanning said model file and said pin configuration file to identify said second tester channel (7) as being available as a substitute for said first tester channel (7) when said first tester channel malfunctions, said tester software replacing said first tester channel (7) in said pin configuration file by said second tester channel (7) in case said first tester channel (7) malfunctions and said second tester channel (7) is identified as being available.

2. The apparatus of claim 1, further comprising a malfunction detection module (102) that generates a log file that identifies said first tester channel (7) when said first tester channel malfunctions.

3. The apparatus of claim 2, wherein said script scans said log file to identify said first tester channel (7) when said first tester channel malfunctions.

4. The apparatus of claim 1, wherein said script is a PERL (Practical Extraction and Reporting Language) script.

5. The apparatus of claim 1, further comprising a switch (8) that switches said second tester channel (7) in place of said first tester channel (7).

6. The apparatus of claim 1 further comprising:
a third tester channel (7); and
a switch matrix (8) controllable to switch either of said second or third tester channels (7) in place of said first tester channel (7).

7. The apparatus of claim 5, wherein said switch includes a relay to activate said second tester channel (7) in place of said first tester channel (7).

8. The automated tester apparatus of claim 1 further comprising:
a switch (8) for switching said second tester channel (7) in place of said first channel (7) when said detector module detects said malfunction of said first tester channel.

9. The apparatus of claim 8, wherein said detector module generates a log file that identifies first tester channel when said first tester channel malfunctions.

10. The apparatus of claim 8, further comprising:
a third tester channel (7); and
a switch matrix (8) controllable to switch either of said second or third tester channels in place of said first tester channel,
wherein said switch is a component of said switch matrix.

11. The apparatus of claim 8, wherein said switch includes a relay (12) to activate said second tester channel (7) in place of said first tester channel (7).

12. The apparatus of claim 8, further comprising:
a module for stopping operation of said first and second tester channels (7),
wherein said detector module is activated in concurrence with said stopping.

13. The apparatus of claim 8, wherein said apparatus provides continued test operation irrespective of tester channel malfunctioning.

14. A method of operating an automated tester apparatus that includes a first tester channel and a second tester channel, the method comprising:
providing a model file that indicates whether said first and second tester channels are available in the tester apparatus;
providing a pin configuration file that indicates whether said first and second tester channels are used by a test program;
scanning said model file and said pin configuration file to identify said second tester channel as being available as a substitute for said first tester channel when said first tester channel malfunctions; and
substituting said second tester channel for said first tester channel in said pin configuration file in case said first tester channel malfunctions and said second tester channel is identified as being available.

15. The method of claim 14, further comprising:
detecting that said first tester channel malfunctions,
wherein said substituting comprises switching said second tester channel in place of said first tester channel.

16. The method of claim 15, further comprising:
stopping operation of said first and second tester channels,
wherein said detecting is performed in concurrence with said stopping.

17. The method of claim 14, wherein said substituting is performed while said apparatus provides continued test operation irrespective of tester channel malfunctioning.

## Patentansprüche

1. Eine automatische Testervorrichtung (10), die folgende Merkmale aufweist:
einen ersten Testerkanal (7) und einen zweiten Testerkanal (7);
eine Modelldatei, die angibt, ob der erste und der zweite Testerkanal (7) in der Testervorrichtung verfügbar sind;
eine Anschlussstiftkonfigurationsdatei, die angibt, ob der erste und der zweite Testerkanal (7) durch ein Testprogramm verwendet werden; und
eine Testersoftware, die zum Abtasten der Modelldatei und der Anschlussstiftkonfigurationsdatei angeordnet ist, um den zweiten Testerkanal (7) als verfügbar als ein Ersatz für den ersten Testerkanal (7) zu identifizieren, wenn der erste Testerkanal eine Fehlfunktion aufweist, wobei die Testersoftware den ersten Testerkanal (7) in der Anschlussstiftkonfigurationsdatei durch den zweiten Testerkanal (7) ersetzt, falls der erste Testerkanal (7) eine Fehlfunktion aufweist und der zweite Testerkanal (7) als verfügbar identifiziert ist.

2. Die Vorrichtung gemäß Anspruch 1, die ferner ein Fehlfunktionserfassungsmodul (102) aufweist, das eine Protokolldatei erzeugt, die den ersten Testerkanal (7) identifiziert, wenn der erste Testerkanal eine Fehlfunktion aufweist.

3. Die Vorrichtung gemäß Anspruch 2, bei der das Skript die Protokolldatei abtastet, um den ersten Testerkanal (7) zu identifizieren, wenn der erste Testerkanal eine Fehlfunktion aufweist.

4. Die Vorrichtung gemäß Anspruch 1, bei der das Skript ein PERL-Skript (PERL = Practical Extraction and Reporting Language = Praktische Extraktions- und Berichtssprache) ist.

5. Die Vorrichtung gemäß Anspruch 1, die ferner einen Schalter (8) aufweist, der den zweiten Testerkanal (7) anstelle des ersten Testerkanals (7) schaltet.

6. Die Vorrichtung gemäß Anspruch 1, die ferner folgende Merkmale aufweist:
einen dritten Testerkanal (7); und
eine Schaltmatrix (8), die steuerbar ist, um entweder den zweiten oder den dritten Testerkanal (7) anstelle des ersten Testerkanals (7) zu schalten.

7. Die Vorrichtung gemäß Anspruch 5, bei der der Schalter ein Relais umfasst, um den zweiten Testerkanal (7) anstelle des ersten Testerkanals (7) zu aktivieren.

8. Die automatische Testervorrichtung gemäß Anspruch 1, die ferner folgendes Merkmal aufweist:
einen Schalter (8) zum Schalten des zweiten Testerkanals (7) anstelle des ersten Testerkanals (7), wenn das Detektormodul die Fehlfunktion des ersten Testerkanals erfasst.

9. Die Vorrichtung gemäß Anspruch 8, bei der das Detektormodul eine Protokolldatei erzeugt, die den ersten Testerkanal identifiziert, wenn der erste Testerkanal eine Fehlfunktion aufweist.

10. Die Vorrichtung gemäß Anspruch 8, die ferner folgende Merkmale aufweist:
einen dritten Testerkanal (7); und
eine Schaltmatrix (8), die steuerbar ist, um entweder den zweiten oder den dritten Testerkanal anstelle des ersten Testerkanals zu schalten,
wobei der Schalter eine Komponente der Schaltmatrix ist.

11. Die Vorrichtung gemäß Anspruch 8, bei der der Schalter ein Relais (12) umfasst, um den zweiten Testerkanal (7) anstelle des ersten Testerkanals (7) zu aktivieren.

12. Die Vorrichtung gemäß Anspruch 8, die ferner folgendes Merkmal aufweist:
ein Modul zum Anhalten eines Betriebs des ersten und des zweiten Testerkanals (7),
wobei das Detektormodul gleichzeitig mit dem Anhalten aktiviert ist.

13. Die Vorrichtung gemäß Anspruch 8, wobei die Vorrichtung ungeachtet einer Testerkanalfehlfunktion einen fortlaufenden Testbetrieb liefert.

14. Ein Verfahren zum Betreiben einer automatischen Testervorrichtung, die einen ersten Testerkanal und einen zweiten Testerkanal umfasst, wobei das Verfahren folgende Schritte aufweist:
Bereitstellen einer Modelldatei, die angibt, ob der erste und der zweite Testerkanal in der Testervorrichtung verfügbar sind;
Bereitstellen einer Anschlussstiftkonfigurationsdatei, die angibt, ob der erste und der zweite Testerkanal durch ein Testprogramm verwendet werden;
Abtasten der Modelldatei und der Anschlussstiftkonfigurationsdatei, um den zweiten Testerkanal als verfügbar als ein Ersatz für den ersten Testerkanal zu identifizieren, wenn der erste Testerkanal eine Fehlfunktion aufweist; und
Ersetzen des ersten Testerkanals mit dem zweiten Testerkanal in der Anschlussstiftkonfigurationsdatei, falls der erste Testerkanal eine Fehlfunktion aufweist und der zweite Testerkanal als verfügbar identifiziert ist.

15. Das Verfahren gemäß Anspruch 14, das ferner folgenden Schritt aufweist:
Erfassen, dass der erste Testerkanal eine Fehlfunktion aufweist,
wobei das Ersetzen ein Schalten des zweiten Testerkanals anstelle des ersten Testerkanals aufweist.

16. Das Verfahren gemäß Anspruch 15, das ferner folgenden Schritt aufweist:
Anhalten eines Betriebs des ersten und des zweiten Testerkanals,
wobei das Erfassen gleichzeitig mit dem Anhalten durchgeführt wird.

17. Das Verfahren gemäß Anspruch 14, bei dem das Ersetzen durchgeführt wird, während die Vorrichtung ungeachtet einer Testerkanalfehlfunktion einen fortlaufenden Testbetrieb liefert.

## Revendications

1. Appareil d'essai automatisé (10) comprenant:
un premier canal d'essai (7) et un deuxième canal d'essai (7);
un fichier de modèle qui indique si lesdits premier et deuxième canaux d'essai (7) sont disponibles dans l'appareil d'essai;
un fichier de configuration de broche qui indique si lesdits premier et deuxième canaux d'essai (7) sont utilisés par un programme de test; et
un logiciel d'appareil d'essai aménagé de manière à balayer ledit fichier de modèle et ledit fichier de configuration de broche, pour identifier ledit deuxième canal d'essai (7) comme étant disponible comme substitut dudit premier canal d'essai (7) lorsque le fonctionnement dudit premier canal d'essai est défectueux, ledit logiciel d'appareil d'essai remplaçant ledit premier canal d'essai (7) dans ledit fichier de configuration de broche par ledit deuxième canal d'essai (7) au cas où le fonctionnement dudit premier canal d'essai (7) est défectueux et ledit deuxième canal d'essai (7) est identifié comme étant disponible.

2. Appareil selon la revendication 1, comprenant par ailleurs un module de détection de fonctionnement défectueux (102) qui génère un fichier journal qui identifie ledit premier canal d'essai (7) lorsque le fonctionnement dudit premier canal d'essai est défectueux.

3. Appareil selon la revendication 2, dans lequel ledit script balaie ledit fichier journal, pour identifier ledit premier canal d'essai (7) lorsque le fonctionnement dudit premier canal d'essai est défectueux.

4. Appareil selon la revendication 1, dans lequel ledit script est un script en PERL (Practical Extraction and Reporting Language).

5. Appareil selon la revendication 1, comprenant par ailleurs un commutateur (8) qui commute ledit deuxième canal d'essai (7) au lieu dudit premier canal d'essai (7).

6. Appareil selon la revendication 1, comprenant par ailleurs:
un troisième canal d'essai (7); et
une matrice de commutation (8) pouvant être commandée pour commuter l'un ou l'autre desdits deuxième ou troisième canaux d'essai (7) au lieu dudit premier canal d'essai (7).

7. Appareil selon la revendication 5, dans lequel ledit commutateur comporte un relais destiné à activer ledit deuxième canal d'essai (7) au lieu dudit premier canal d'essai (7).

8. Appareil d'essai automatisé selon la revendication 1, comprenant par ailleurs:
un commutateur (8) destiné à commuter ledit deuxième canal d'essai au lieu dudit premier canal d'essai (7) lorsque ledit module de détection détecte ledit fonctionnement défectueux dudit premier canal d'essai.

9. Appareil selon la revendication 8, dans lequel ledit module de détection génère un fichier journal qui identifie le premier canal d'essai lorsque le fonctionnement dudit premier canal d'essai est défectueux.

10. Appareil selon la revendication 8, comprenant par ailleurs:
un troisième canal d'essai (7); et
une matrice de commutation (8) pouvant être commandée pour commuter l'un ou l'autre desdits deuxième ou troisième canaux d'essai (7) au lieu dudit premier canal d'essai,
dans lequel ledit commutateur est un composant de ladite matrice de commutation.

11. Appareil selon la revendication 8, dans lequel ledit commutateur comporte un relais (12) destiné à activer ledit deuxième canal d'essai (7) au lieu dudit premier of canal d'essai (7).

12. Appareil selon la revendication 8, comprenant par ailleurs:
un module destiné à arrêter le fonctionnement desdits premier et deuxième canaux d'essai (7),
dans lequel ledit module de détection est activé en même temps que ledit arrêt.

13. Appareil selon la revendication 8, dans lequel ledit appareil permet un fonctionnement de test en continu indépendamment du fonctionnement défectueux du canal d'essai.

14. Procédé pour faire fonctionner un appareil d'essai automatisé qui comporte un premier canal d'essai et un deuxième canal d'essai, le procédé comprenant:
prévoir un fichier de modèle qui indique si lesdits premier et deuxième canaux d'essai sont disponibles dans l'appareil d'essai;
prévoir un fichier de configuration de broche qui indique si lesdits premier et deuxième canaux d'essai sont utilisés par un programme de test;
balayer ledit fichier de modèle et ledit fichier de configuration de broche, pour identifier ledit deuxième canal d'essai comme étant disponible comme substitut pour le premier canal d'essai lorsque le fonctionnement dudit premier canal d'essai est défectueux; et
substituer ledit deuxième canal d'essai audit premier canal d'essai dans ledit fichier de configuration de broche au cas où le fonctionnement dudit premier canal d'essai est défectueux et ledit deuxième canal d'essai est identifié comme étant disponible.

15. Procédé selon la revendication 14, comprenant par ailleurs:
détecter que le fonctionnement dudit premier canal d'essai est défectueux,
dans lequel ladite substitution comprend la commutation dudit deuxième canal d'essai au lieu dudit premier canal d'essai.

16. Procédé selon la revendication 15, comprenant par ailleurs:
arrêter le fonctionnement desdits premier et deuxième canaux d'essai,
dans lequel ladite détection s'effectue en même temps que ledit arrêt.

17. Procédé selon la revendication 14, dans lequel ladite substitution est effectuée tandis que ledit appareil permet un fonctionnement d'essai en continu indépendamment du fonctionnement défectueux du canal d'essai.
